(19)

Europäisches
Patentamt
European
Patent Office
Office européen
des brevets

(11) **EP 2 272 996 A1**

(12) **EUROPEAN PATENT APPLICATION**

(43) Date of publication:
**12.01.2011 Bulletin 2011/02**

(21) Application number: **10168910.7**

(22) Date of filing: **08.07.2010**

(51) Int Cl.:
**C23C 16/40** (2006.01)          **C23C 16/56** (2006.01)
**H01L 21/312** (2006.01)

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **08.07.2009 US 223961 P**

(71) Applicants:
• **IMEC**
  **3001 Leuven (BE)**
• **Katholieke Universiteit Leuven, K.U.L. Leuven R&D**
  **3000 Leuven (BE)**

(72) Inventors:
• **Urbanowicz, Adam**
  **3001, Leuven (BE)**

• **Verdonck, Patrick**
  **1933 Sterrebeek (BE)**
• **Shamiryan, Denis**
  **3001, Leuven (BE)**
• **Vanstreels, Kris**
  **3740, Bilzen (BE)**
• **Baklanov, Mikhaïl**
  **3020, Veltem-Beisem (BE)**
• **De Gendt, Stefan**
  **2110, Wijnegem (BE)**

(74) Representative: **Bird, William Edward et al**
  **Bird Goën & Co**
  **Klein Dalenstraat 42A**
  **3020 Winksele (BE)**

(54) **Fabrication of porogen residue free and mechanically robust low-k materials**

(57)     A method is disclosed to produce a porogen-residue-free ultra low-k film with porosity higher than 50% and a high elastic modulus above 5 GPa. The method starts with depositing a SiCOH film using Plasma Enhanced Chemical Vapour Deposition (PE-CVD) or Chemical Vapour Deposition (CVD) onto a substrate and then first Performing an atomic hydrogen treatment at elevated wafer temperature in the range of 200 °C up to 350 °C to remove all the porogens and then performing a UV assisted thermal curing step.

Figure 4

## Description

### Field

The present disclosure is related to the fabrication of porous low-k materials, more specifically to plasma enhanced chemically vapour deposited (PE-CVD) and chemically vapour deposited (CVD) low-k films used as dielectric materials in between interconnect structures in semiconductor devices.

More particular, a new method is provided which results in a low-k material with significant improved elastic modulus, and hardness, for a porosity obtained. An elastic modulus, or modulus of elasticity, is the mathematical description of an object or substance's tendency to be deformed elastically (i.e., non-permanently) when a force is applied to it. The elastic modulus of an object is defined as the slope of its stress-strain curve in the

elastic deformation region: $\lambda \overset{\text{def}}{=} \dfrac{\text{stress}}{\text{strain}}$

where lambda ($\lambda$) is the elastic modulus; stress is the force causing the deformation divided by the area to which the force is applied; and strain is the ratio of the change caused by the stress to the original state of the object. If stress is measured in Pascal, since strain is a unitless ratio, then the units of $\lambda$ are Pascal as well.

Since the denominator becomes unity if length is doubled, the elastic modulus becomes the stress needed to cause a sample of the material to double in length. While this endpoint is not realistic because most materials will fail before reaching it, it is practical, in that small fractions of the defining load will operate in exactly the same ratio. Thus for steel with an elastic modulus of 30 million pounds per square inch, a 30 thousand psi load will elongate a 1 inch bar by one thousandth of an inch, and similarly for metric units, where a thousandth of the modulus in GPascal will change a meter by a millimetre.

Specifying how stress and strain are to be measured, including directions, allows for many types of elastic moduli to be defined. The three primary ones are:

Young's modulus (E) describes tensile elasticity, or the tendency of an object to deform along an axis when opposing forces are applied along that axis; it is defined as the ratio of tensile stress to tensile strain. It is often referred to simply as the elastic modulus. In the present application elastic modulus primarily relates to the Young's modulus.

The shear modulus or modulus of rigidity (G or $\mu$) describes an object's tendency to shear (the deformation of shape at constant volume) when acted upon by opposing forces; it is defined as shear stress over shear strain. The shear modulus is part of the derivation of viscosity.

The bulk modulus (K) describes volumetric elasticity, or the tendency of an object to deform in all directions when uniformly loaded in all directions; it is defined as volumetric stress over volumetric strain, and is the inverse of compressibility. The bulk modulus is an extension of Young's modulus to three dimensions.

The examples further relate to the use of a $H_2$-comprising plasma afterglow (such as described in the examples, comprising $He/H_2$) and Ultra-Violet (UV) exposure.

### State of the art

The ITRS roadmap for scaling of ultra-large-scale integrated circuits requires mechanically robust dielectric materials with a low k-value. Low-k materials currently used in Cu/low-k integration scheme have k-values between 2.3 and 3.0. In semiconductor manufacturing, a low-$\kappa$ dielectric is a material with a small dielectric constant relative to silicon dioxide. Although the proper symbol for the dielectric constant is the Greek letter $\kappa$ (kappa), in conversation such materials are referred to as being "low-k" (low-kay) rather than "low-$\kappa$" (low-kappa). Low-$\kappa$ dielectric material implementation is one of several strategies used to allow continued scaling of microelectronic devices, colloquially referred to as extending Moore's law. In integrated circuits, insulating dielectrics separate conducting parts (such as wire interconnects) from one another. As components have scaled and transistors have got closer together, the insulating dielectrics have thinned to the point where charge builds up and crosstalk adversely affects the performance of the device. Replacing the silicon dioxide with a low-$\kappa$ dielectric of the same thickness reduces parasitic capacitance, enabling faster switching speeds and lower heat dissipation. The dielectric constant of $SiO_2$, the insulating material used in silicon chips, is 3.9. This number is the ratio of the permittivity of $SiO_2$ divided by permittivity of vacuum, $\varepsilon SiO_2/\varepsilon 0$, where $\varepsilon 0 = 8.854 \times 10^{-6}$ pF/$\mu$m. There are many materials with lower dielectric constants but few of them can be suitably integrated into a manufacturing process. Development efforts have focused primarily on three classes of materials:

Fluorine-doped silicon dioxide. By doping $SiO_2$ with fluorine to produce fluorinated silica glass, the dielectric constant is lowered from 3.9 to 3.5.

Carbon-doped silicon dioxide. By doping $SiO_2$ with carbon, one can lower the dielectric constant to 3.0. Major products of carbon doped silicon dioxide include Black Diamond from Applied Materials, Aurora from ASM International N.V. The Aurora is a low-$\kappa$ material used in Intel 90 nm, 65 nm and 45 nm lines, while the Black Diamond controlled about 80% of low-$\kappa$ material market. Novellus Systems' Coral also falls in this category.

Porous silicon dioxide. Various methods may be employed to create large voids or pores in a silicon dioxide dielectric. Air has a dielectric constant of roughly 1.0005, thus the dielectric constant of the porous material may be reduced by increasing the porosity of the film. Dielectric constants lower than 2.0 have been reported. Integration difficulties related to porous silicon dioxide implementation include low mechanical strength and difficult integration with etch and polish processes.

Porous carbon-doped silicon dioxide. By UV curing, floating methyl group in carbon doped silicon dioxide can be eliminated and pores can be introduced to the carbon doped silicon dioxide low-$\kappa$ materials. Products in this category include Black Diamond II, Aurora 2.7, Aurora 2.5 and Aurora ULK (k=2.3). The reported $\kappa$ value can be as low as 2.3(but only self-assembly films with k-value 2.3 are integrated such as NCS).

Spin-on organic polymeric dielectrics. Polymeric dielectrics are generally deposited by a spin-on approach, such as those traditionally used to deposit photo-resist, rather than chemical vapour deposition. Integration difficulties include low mechanical strength and thermal stability. SiLK from Dow Chemical is a well known example of low-$\kappa$ material in this category. Other spin-on organic low-$\kappa$ include polyimide, polynorbornenes, Benzocyclobutene, PTFE. Porous SiLK. By introducing pores into the SiLK resin, the dielectric constant value can be lowered to 2.2. Spin-on silicone based polymeric dielectric. There are two kinds of silicone based polymeric dielectric materials, hydrogen silsesquioxane (HSQ) and methylsilsesquioxane (MSQ).

One of the limiting factors in further reduction of k-value is mechanical robustness, since more than 32 % of porosity needs to be introduced to a Plasma Enhanced Chemically Vapour Deposited (PE-CVD) or Chemically Vapour deposited (CVD) low-k film to achieve the k-values below 2.3. Such k-values are typically referred to as ultra low-k (or ULK). Preferably these k-values are below 2.0, such as below 1.9.

In state of the art (Kemeling et al. in Microelectronic Engineering Volume 84, Issue 11, November 2007, Pages 2575-2581) PE-CVD deposited low-k films such as Aurora® ELK films are fabricated by PE-CVD of a Si-COH matrix precursor and an organic porogen material. The porogen material is in the prior art then removed during a subsequent thermally assisted UV-cure step with a short wavelength UV-lamp ($\lambda < 200$ nm). However, a certain amount of porogen residues remain (such as amorphous carbon, cyclic hydrocarbons) which are amongst others generated during ultra-violet (UV) curing process are formed which need to be removed. Degradation of the mechanical properties as a result of porogen residue removal from advanced PECVD low-k films (k<2.3) during the ash has been recognized as an integration challenge. Typically this further results in film thickness shrinkage of 13.2% and a robust low-k film with k-value of 2.3 and elastic modulus of 5.0 GPa. A further increase in elastic modulus without altering the k value (porosity) is however desired in order to withstand further processing and reliability of the device (such as chemical mechanical polishing (CMP) process). Further, typically hydrophilic dielectrics are formed, which is undesirable from a production point of view. In some prior art also a wet chemical process is involved, which is also undesirable in view of further production processes.

## Summary of the invention

The present invention as supported by examples achieves a mechanically robust and hydrophobic ultra low-k film (wherein preferably k < 1.8, but also a k-value in a range of 1.8-2.6, such as 1.8-2.3), further having improved optical, chemical and mechanical properties. The film is further hydrophobic in nature, as is shown by a contact angle of >90° with water.

The examples further achieve starting from a PE-CVD or CVD deposited SiCOH film a porogen-residue-free ultra low-k film having a porosity higher than 50% and a high elastic modulus higher than 5 GPa.

It is an object of the present invention to provide a new curing procedure for Plasma Enhanced Chemical Vapour Deposited (PE-CVD) and Chemical Vapour Deposited (CVD) SiCOH films in order to achieve a porogen-residue-free ultra low-k film with porosity higher than 50% and a high elastic modulus (higher than 5 GPa).

The examples solve the problem of presence of porogen residues (amorphous carbon, cyclic hydrocarbons) generated during state of the art ultra-violet (UV) curing processes of PE-CVD and CVD deposited SiCOH films. State of the art curing processes use UV curing to enhance mechanical properties and to remove porogens simultaneously. However during the UV curing problems are encountered leading to deterioration of the low-k film because firstly not all of the porogens are removed and secondly because part of the porogens are transformed into porogen residues which are nearly impossible to remove afterwards. Furthermore thermal curing also creates a porogen residues problem. State of the art UV curing therefore sometimes incorporates an additional plasma treatment step (ashing) to remove these porogen residues afterwards, typically these plasma treatments result in degradation of the mechanical properties of low-k films (see Urbanowicz et al., Electrochemical Solid-State Letters Vol. 12, issue 8, Semiconductor Devices, Materials, and Processing).

The examples solve the problem of low-k materials having weak mechanical properties due to cross-linked porogen (more specifically porogen residues) incorporated into Si-O-Si matrix of the SiCOH film. These porogen residues are generated during the UV curing process whereby porogen residues are formed within the matrix of the low-k film.

It has been experimentally found that the presence of porogens during an UV curing step will partially prevent optimal Si-O-Si matrix cross-linking which results in weak mechanical properties of Plasma Enhanced Chemical Vapour Deposited PE-CVD and Chemical Vapour Deposited low-k films (e.g. in comparison with self-assembly organ-silica based films such as NCS). Thus, the presence of porogens has been discovered to be detrimental for the UV curing process. The UV curing step is further in an example carried out at a wavelength of < 200 nm. In the example a wavelength for the curing step in the invention is preferably from 160-180 nm, such as around 172 nm. Thereto an ASM curing system using Eagle 12 -platform is suitable. It has been found experimentally that such a wavelength does not cause Si-H generation, in contrast to prior art curing processes at a wavelength > 200 nm. It has been found that the Young's Modulus improves significantly for both films with (some 20%, e.g. 6 GPa versus 5 GPa) en without (some 75%, e.g. 6.5 GPa versus 3.5 GPa) porogens when UV-light of about 172 nm is used in stead of UV-light of about 200 nm. It is noted that both films (with and without porogens) show an improvement in the Young's Modulus when UV-cured compared to non-cured films. Further, it has been found that the open porosity increases for films with porogens, and decreases for films without porogens when UV-light of about 172 nm is used in stead of UV-light of about 200 nm.

A film cross-linking signature is its shrinkage after UV-hardening process. The shrinkage is reflected in thickness loss of the film (measured by UV-SE) after UV-irradiation It has been shown experimentally that irradiation of porogen-containing and porogen-free films by narrow band UV source of 172 nm leads to a higher thickness loss than for broadband light with a wavelength higher than 200 nm. It is believed that such indicates that a degree of film cross-linking is higher when a narrow band 172 nm UV source is used for film curing. Moreover, there is a clear difference in film thickness loss depending on the UV wavelength used for curing. This difference is smaller for porogen-containing films and higher for the porogen-free films. For instance, the thickness loss is significantly higher for 172 nm UV than for 200 nm UV when films are cured without porogen. In a case when only hydrogen is used a minimal change of thickness occurs. This indicates that the latter does not results in the film cross-linking.

It is believed that a degree of film cross-linking is reflected in its thickness loss. As a result improvement of Young's modulus is observed. Further, it has been found that porosity is lower when films are UV-cured with porogen. This seems to be caused by conversion of some part of the porogen by UV-light into porogen residues. The achieved Young's Moudulus are slightly better when a porogen-containing film is cured with 172 nm UV source. On the contrary the improvement in Young's Moudulus is almost 2 times higher for 172 nm UV than for 200 nm UV if the films are cured without porogen. This shows that presence or absence of porogens during UV-curing has a strong impact on the Young's Moudulus. It has been shown that UV-curing with a wavelength in the range of 200 nm to 400 nm significantly limits the improvement of Young's Moudulus of films. Therefore, in order to achieve a mechanically robust film in the present invention UV-light with a wavelength of around 172 nm is used.

The examples solve the problem of avoiding remaining porogen residues by performing prior to the UV assisted thermal curing step a treatment of the PE-CVD and CVD-deposited SiCOH films in the afterglow of a hydrogen ($H_2$) -based plasma (with optional additions of noble gasses such as He, Ar) at elevated temperatures in the range of 200 °C - 350 °C. A Reactive ion etching plasma (RIE) is to be avoided and will not result in the desired result. Furthermore additions of nitrogen are to be avoided.

The method of the examples hence involves in a first step a substantially, typically more than 95%, such as more than 99%; complete removal of the porogens by atomic hydrogen at elevated temperature (200 °C-350 °C). The atomic hydrogen might be generated using a hydrogen comprising plasma afterglow or any other means and then in a second step a UV-assisted thermal curing step. The idea is to perform first a treatment with atomic hydrogen in order to remove almost all the porogens present in the matrix of the SiCOH film, during said treatment nothing is changed to the matrix. Said atomic hydrogen treatment is in an example performed by using a suitable hydrogen comprising DownStream Plasma (DSP), by using the right plasma conditions and plasma composition it is possible to achieve only a chemical reaction and to remove the porogens without influencing the matrix of the film (no Si-O and Si-$CH_3$ bonds destruction). It has been found experimentally that a special design of plasma chamber eliminates effect of UV-light H+ ions and He meta-stable atoms. A noble gas is added to improve H radical concentration. Said suitable plasma in an example is a plasma without charged species (electrons, excited radicals, UV light) and is referred to as "an after glow plasma", "remote plasma" or "DownStream plasma". Using said plasma treatment step will not change the matrix of the SiCOH film. Only after complete removal of the porogens, a UV curing step is performed in order to improve low-k matrix cross-linking. In a second step a SiCOH film is cured using a UV assisted thermal curing step.

Using the sequence of steps according to the examples makes it possible to achieve porogen-residue-free ultra low-k films with porosity higher than 50% and high elastic modulus of above 5 GPa.

The above objective is accomplished by a method and according to examples.

In a first aspect, examples provide a method for producing a porogen-residue-free ultra low-k film having a k of 1.8-2.6, preferably a k < 2.0, with a porosity higher than 45%, preferably higher than 48%, and an elastic modulus above 3 GPa such as above 5 GPa, said method comprising at least the steps of:

- (a) Providing a substrate (1), such as Si,
- (b) Depositing an organo-silica matrix comprising organic porogen, such as cyclic aromatic hydrocarbon, such as by a SiCOH film (2) using Plasma Enhanced Chemical Vapour Deposition (PE-CVD) or Chemical Vapour Deposition (CVD) or spin-on deposition, followed by
- (c) Performing an porogen removal step, such as by atomic hydrogen treatment at a wafer temperature in the range of 200 °C up to 430 °C during a time of 10-800 sec., preferably during 10-700 sec., and then followed by
- (d) Performing a curing step, preferably a UV assisted thermal curing step, preferably at a wavelength of below 200 nm, such as around 172 nm, and
- Optionally repeating steps (b)-(c) one or more times and repeating step (d) one or more times.

The open porosity measurement is measured by Ellipsometric Porosimetry (EP). The open porosity measured by EP is the film volume permeable by toluene. The total porosity is open porosity plus closed porosity.

It is noted that a too high temperature in the atomic hydrogen treatment, aimed at removing porogen residues, is likely to further cause matrix cross-linking, which is regarded as unfavourable. At a too low temperature the porogen removal is not adequate.

According to examples, said SiCOH film is a PE-CVD or CVD deposited SiCOH film, more specifically for example a commercial available Aurora ELK® film with film thickness in between 20 nm and 190 nm, preferably in between 40 nm and 140 nm. The porogen residue removal treatment of a film is limited by e.g. the chemistry, temperature, and process time thereof to a certain thickness, such as 190 nm. Thicker films might be achieved by subsequent (repeated) depositions and He/H2 exposures with final UV-curing step. The porogen can be remove in-situ using special design of plasma chamber (PECVD chamber that allows PECVD film deposition with subsequent H2-afterglow exposures. The thickness of the film is on the other hand limited by e.g. capacitance required and break through voltage, such as to 20 nm.

According to examples, said atomic hydrogen treatment is performed in the afterglow of hydrogen comprising plasma thereby avoiding the presence of hydrogen excited radicals and ions, electrons, UV light. Said hydrogen comprising plasma may further comprise He or any other noble gases such as He, Ne, Ar, Kr, Xe, or the like in order to dilute the hydrogen plasma. Said addition of noble gases such as He may enhance the effect of hydrogen by increasing the number of H atoms in the afterglow of the hydrogen comprising plasma (i.e. increases depth of porogen removal normalized to exposure time).

According to examples, said atomic hydrogen treatment is performed in the afterglow of a hydrogen comprising plasma, said hydrogen comprising plasma is characterized as having preferably a microwave power of around 100-2500 W (e.g. 2500 W), a gas pressure of 13,3 Pa (100 mTorr) up to 100-300 Pa (several Torr) (e.g. 100 Pa (750 mTorr)). The gas flow of hydrogen is preferably in the range of 950 sccm hydrogen. Such conditions are experimentally found to provide optimal results, in terms of mechanical, chemical, and optical characteristics of films obtained. In case a noble gas is added to the plasma, the ratio of noble gas towards hydrogen is preferably from 1/1 to 50/1, such as 5/1 to 30/1, such as around 20/1, e.g. 4000 sccm He and 200 sccm $H_2$. Such conditions are experimentally found to provide optimal results, in terms of mechanical, chemical, and optical characteristics of films obtained.

According to examples, said atomic hydrogen treatment is performed at elevated wafer temperature in the range of 200 °C up to 430 °C, such as 250 °C up to 350 °C, preferably around 280 °C.

According to examples, said atomic hydrogen treatment may be performed using other suitable techniques such as formation of atomic hydrogen using catalytic conversion reactions. An example hereof is using a hot Ti wire, and/or causing hydrolysis of $H_2$.

According to examples, said UV assisted thermal curing step is performed in a temperature range of 300 °C up to 500 °C, such as from above 350 °C up to 450 °C, more preferably at a temperature of 430 °C. It is noted that typically industrial processes use a temperature of 180 °C up to 350 °C, preferably about 250 °C. Therefore the present temperature is somewhat higher. The temperature is preferably not too high, as dielectric films may be damaged. By too low temperatures curing is not complete.

In a second aspect, examples provide low-k film, such as an ILD or IMD, having a k-value k of 1.8-2.6, preferably a k < 2.0, having a porosity of 41%-60%, preferably higher than 48%, and high elastic modulus of above 2 GPa, preferably above 5 GPa, such as above 7 GPa, such as 9.5 GPa, preferably having a thickness of a multiple of 60-140 nm, preferably having an open porosity of less than 40%, such as 32%-36%, preferably having an average pore radius from 0.6 - 3.0 nm, more preferably from 0.7-2 nm, most preferably from 0.8-1.8 nm, such as from 1.5-1.6 nm. Said by example SiCOH deposited low-k film is further characterized as not having (or almost no) porogen or porogen residues in the skeleton of the SiCOH matrix of the low-k film. Such superior films are not provided by prior art methods.

Furthermore, the use of the method according to examples in the fabrication of a low-k film is disclosed wherein the achieved low-k film is used as a dielectric material in between interconnect structures in semiconductor devices.

In a further aspect the present invention relates to an electronic element, such as diode, transistor, MEMS, capacitor, comprising a low-k film according to the invention.

In a further aspect the present invention relates to a semiconductor device comprising a low-k film according to the invention.

In a further aspect the present invention relates to an integrated circuit comprising a low-k film according to the invention.

In a further aspect the present invention relates to an electronic equipment or component, such as an RFID, television, audio, video, telephone, microphone, comprising a semiconductor device according to the invention, and/or an integrated circuit according to the invention, and/or an electronic element according to the invention.

Particular and preferred aspects are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the figures**

Figures are intended to illustrate various aspects and examples of the invention. The figures are depicted in a simplified way for reason of clarity. Not all alternatives and options are shown therein. The invention is not limited to the content of the given drawings. Like numerals are employed to reference like parts in the different figures.

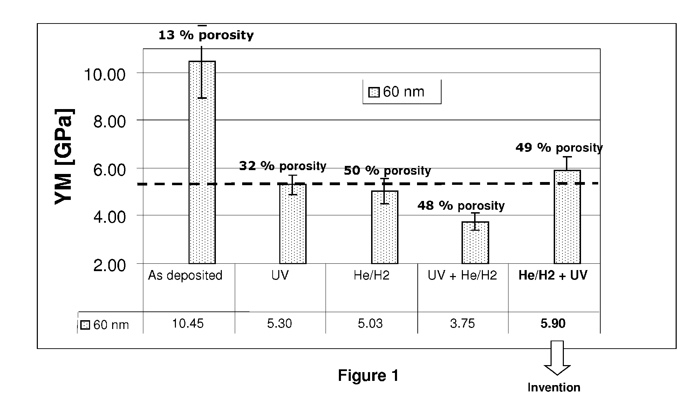

Figure 1 illustrates mechanical properties (e.g. Young Modulus, YM) measured using Nano-Indentation of a PE-CVD or CVD deposited low-k film as deposited, after using state of the art curing methods and using the curing method according to the examples (indicated as "He/H$_2$ + UV"). It is unexpectedly found that with the present method much better films can be obtained, e.g. in terms of porosity and in terms of elastic modulus. Even a reversal of curing and porogen removal step does not result in the superior results of the present invention. Nanoindentation is a variety of indentation hardness tests applied to small volumes. Indentation is perhaps the most commonly applied means of testing the mechanical properties of materials. The nanoindentation technique was developed in the mid 1970s to measure the hardness of small volumes of material. In nanoindentation small loads and tip sizes are used, so the indentation area may only be a few square micrometres or even nanometres. This presents problems in determining the hardness, as the contact area is not easily found. Atomic force microscopy or scanning electron microscopy techniques may be utilized to image the indentation, but can be quite cumbersome. Instead, an indenter with a geometry known to high precision (usually a Berkovich tip, which has a three-sided pyramid geometry) is employed. During the course of the instrumented indentation process, a record of the depth of penetration is made, and then the area of the indent is determined using the known geometry of the indentation tip. While indenting various parameters, such as load and depth of penetration, can be measured. A record of these values can be plotted on a graph to create a load-displacement curve. These curves can be used to extract mechanical properties of the material.

Young's Modulus: The slope of the curve, $dP / dh,$ upon unloading is indicative of the stiffness S of the contact. This value generally includes a contribution from both the material being tested and the response of the test device itself. The stiffness of the contact can be used to calculate the reduced Young's modulus $E_r$:

$$E_r = \frac{1}{\beta} \frac{\sqrt{\pi}}{2} \frac{S}{\sqrt{A_p(h_c)}},$$

where $A_p(h_c)$ is the projected area of the indentation at the contact depth $h_c$, and $\beta$ is a geometrical constant on the order of unity.

Figure 2 illustrates elastic modulus versus porosity of a PE-CVD or CVD deposited low-k film as deposited, after using a (UV) curing method followed by porogen residue removal by He/H$_2$, and after using the curing method according to the examples (indicated as "He/H$_2$ + UV").

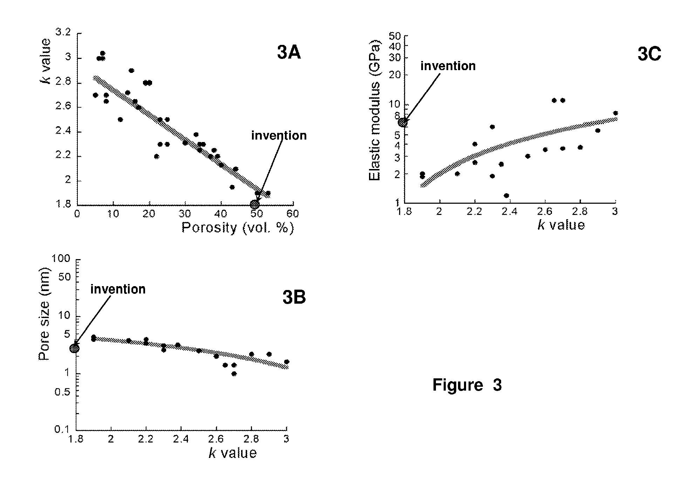

Figures 3A-3C illustrate porosity, pore size and elastic modulus versus k-values for commercial available state of the art low-k materials. The values obtained for the PE-CVD or CVD deposited low-k film using the curing method of the examples is also indicated. In figure 3A it is shown that the present invention provides ultra low-k value films, such as less than 2.0, typically in the order of 1.8, having a high porosity. In figure 3B it is shown that the present invention provides ultra low-k value films, such as less than 2.0, typically in the order of 1.8, having a (average) pore size of about 5 nm. Also smaller pore sizes can be obtained (not shown). In figure 3C it is shown that the present invention provides ultra low-k value films, such as less than 2.0, typically in the order of 1.8, having an unexpectedly high Elastic modulus, of about 5 GPa, where typically values of about 2 GPa are obtained.

Figures 4A-4D illustrate a method according to examples.

Figure 5A-5B illustrates a mechanism of crosslinking using a method of the examples. Figure 5A illustrates a porogen removal within a deposited SiCOH low-k film using $H_2$ comprising DSP plasma treatment according to the examples.

Figure 5B illustrates curing of deposited SiCOH low-k film after total removal of porogens using a (subsequent) thermal UV curing step.

## Detailed description of the examples

The present invention will be described with respect to particular embodiments and with reference to certain drawings. The invention is not limited thereto, the scope of protection is given by the claims. The drawings described are only schematic and are non-limiting. In the drawings, the size of some of the elements may be exaggerated and/or not drawn on scale for illustrative purposes. The dimensions and the relative dimensions do not correspond to actual reduction to practice of the invention.

Moreover, the term top and the like in the description and the claims are used for descriptive purposes and not necessarily for describing relative positions. It is to be understood that the terms so used are interchangeable under appropriate circumstances and that the examples described herein are capable of operation in other orientations than described or illustrated herein.

It is to be noticed that the term "comprising", used in the claims, should not be interpreted as being restricted to means listed thereafter; it does not exclude other elements or steps. It is thus to be interpreted as specifying presence of stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It indicates that with respect to the present invention, relevant components of the device are A and B.

Reference throughout this specification to "one embodiment" (or example) or "an embodiment" means that a particular feature, structure or characteristic described in connection with the embodiment (example) is included in at least one embodiment (example) of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary examples, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that examples may be practiced without these specific details. In other instances, well-known methods, structures and techniques have not been shown in detail in order not to obscure an understanding of this description.

The following terms are provided and defined in order to aid in the understanding of the invention.

The term "low-k" is referring to a dielectric material featuring a dielectric constant k lower than 3.9 (which is k of $SiO_2$) and such is typically used to insulate, such as adjacent metal lines (interlayer dielectric, ILD) in advanced integrated circuits.

A "porous dielectric (low-k) material" is referring to a material in which porosity is created in the dielectric material to reduce its dielectric constant.

The term "porogens" refers to organic material, more specifically to an unstable sacrificial Carbon-hydrogen comprising phase in addiction to the SiCOH skeleton phase. By treating the films after deposition to remove the unstable phase from the material porosity is created.

The term Plasma Enhanced Chemical Vapour Deposited (PE-CVD) and Chemical Vapour Deposited (CVD) low-k films refers to SiCOH deposited films comprising porogens, also referred to as "hybrid" SiCOH films . Porosity in said films is typically achieved using UV thermal assisted curing during which mechanical strength is reduced and porogens are removed. Alternatively e-beam and thermal curing are used. Said SiCOH films are also referred to as "Organo Silicate Glass" (OSG) and "Carbon Doped Oxides" (CDO).

The term "afterglow plasma", "remote plasma" and "downstream plasma" are all referring to plasma conditions used to perform a step of removing porogens in a PE-CVD or CVD deposited SiCOH film in the examples and refer to a plasma in which a substrate (wafer) is located away from the plasma, and hence, is not directly exposed to the plasma and where desired chemical reactions are implemented by extracting species from the plasma and directing them toward the substrate. These plasma conditions result in a generation of atomic Hydrogen without presence of energetically excited or charged species and photons. In such a way only pure chemical spontaneous reactions with atomic hydrogen and the film are possible (avoiding physical interaction).

The invention will now be described by a detailed description of several examples. It is clear that other examples can be configured according to the knowledge of persons skilled in the art without departing from the true spirit or technical teaching of the invention as defined by the appended claims.

A method is provided for the fabrication and curing of a porogen and/or porogen residues free PE-CVD or CVD deposited SiCOH low-k film.

A present goal is to achieve a porogen (porogen residue) free low-k film with significant improved porosity, improved elastic modulus, and improved mechanical properties (hardness). Further, also an improved leakage current, improved Breakdown voltage and improved TDDB are obtained.

Porogen removal during an UV assisted curing process partially prevents Si-O-Si matrix cross-linking due to formation of porogen residues during this thermal UV curing step and this results in weak mechanical properties of PE-CVD and CVD low-k films. Porogen residues can be the further removed during ash process however this results in further degradation of mechanical properties.

According to examples better mechanical properties are obtained for PE-CVD and CVD deposited SiCOH low-k films using first a $H_2$-comprising DSP plasma treatment followed by a UV assisted thermal curing. Thereby significantly all, such as more than 94%, of the porogens are removed before the step of UV assisted thermal curing and hence more cross-linking of the Si-O matrix can be achieved because the cross-linking is no longer limited by the presence of porogens and/or porogen residues in the film. It has been understood after studying the present materials that the cross-linking of Si-O bonds gives the good mechanical properties (Young Modulus of $SiO_2$ = 72 GPa) and this cross-linking will result in a Si-O-Si matrix which has a main influence on the final elastic modulus (also referred to as Young Modulus, YM, hardness) of the low-k film.

Using a method of the examples it is possible to achieve optimal cross-linking of the film without losing its hydrophobicity.

Using a method of the examples it is possible to achieve a low-k film with porosity higher than 48%, such as higher than 50% and high elastic modulus of above 5 GPa.

An example of the method comprises after depositing a SiCOH film using Plasma Enhanced Chemical Vapour Deposition (PE-CVD) or Chemical Vapour Deposition (CVD) onto a substrate a first step of performing an atomic hydrogen treatment at elevated wafer temperature (200 °C - 350 °C) and then in a second step performing a UV assisted thermal curing step. These steps may be repeated, once or more. The atomic hydrogen treatment is for example carried out during a time of 10-800 seconds. Such will depend e.g. on thickness of a layer deposited, temperature chosen, and specific chemistry used therein. For a layer of 60 nm about 35 seconds is sufficient. If time is too long the elastic modulus will typically deteriorate. The depth of removal is somewhat limited, due to the chemistry used. Therein H-radical may recombine on low-k film pore walls. The amount of water absorbed is preferably as low as possible, such as lower than 1%; thereto a relatively higher temperature is chosen, such as indicated above. As a consequence the (matrix of) films is hydrophobic. The open porosity is preferably is as high as possible, such as from 32-36% thereto a temperature of 280 °C - 350 °C is chosen. By choosing a higher temperature, e.g. 300-350 °C the mean (or average) pore diameter can be increased somewhat, e.g. by 20-100%, compared to the state of the art methods, such as from about 1 nm to about 2 nm.

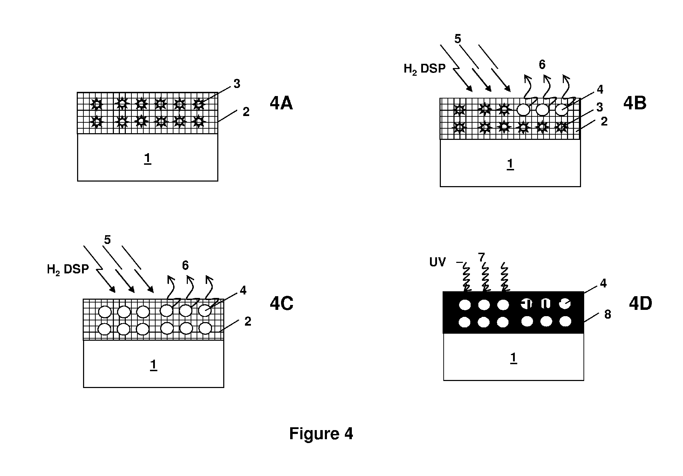

Figure 4 illustrates different steps of an example of the method. In a first step, as illustrated in Figure 4A, a SiCOH film 2 comprising porogens 3 is deposited using Plasma Enhanced Chemical Vapour Deposition (PE-CVD) or Chemical Vapour Deposition (CVD) onto a substrate 1. Said film has preferably a thickness in the range of 100nm up to 140nm. Figure 4B and 4C illustrate the plasma treatment step 5 using a $H_2$ comprising after glow plasma to remove all of the porogens 3 in the SiCOH film such that open pores 4 are created within the SiCOH film 2. Figure 4D illustrates the UV thermal assisted curing step 6 during which the mechanical strength of the final SiCOH film 7 is improved and in which new bonds are created.

Figure 1 illustrates mechanical properties (Young Modulus, YM) measured using Nano-Indentation of a PE-CVD or CVD deposited low-k film as deposited, after using state of the art curing methods and using the curing method according to the examples (indicated as "He/$H_2$ + UV"). A film having a Young modulus of 5.90 and a porosity of 49% is achieved using the method of the examples. The surface hydrophobic properties before and after the plasma treatments were evaluated using water contact angle measurements (WCA). Optical properties were determined by SE in the spectral range of 150 to 895 nm at an incidence angle of 70° using Aleris SE from KlaTencor. The results were fitted by a single and a double layer optical model using a Marquardt-Levenberg algorithm. The optical models were constructed as described in the literature. The depth of modification and the optical properties of 190 nm films were estimated using a double layer SE model. The bottom layer was assumed to have optical properties of the as deposited film, while the optical characteristics of the top modified layer were determined by fitting. The mass change related to plasma treatments was measured by mass balance metrology on 300 mm wafers (Metrix: Mentor SF3). The open porosity and pore size distributions (PSDs) were evaluated using ellipsometric porosimetry (EP). Mechanical properties, YM and hardness of the low-k dielectric films were measured using a Nanoindenter XP® system (MTS Systems Corporation) with a dynamic contact module and a continuous stiffness measurement option under the constant strain rate condition. A standard three-sided pyramid diamond indenter tip (Berkovich) was used for the indentation experiments. As the indenter tip is pressed into each sample, both depth of penetration (h) and the applied load (P) are monitored. The YM values of thin OSGs could be influenced by Si substrate effect. The Si substrate effect might vary depending on film thickness. In order to exclude potential error in YM values the film with different thicknesses are investigated in this study. Next, a load-versus depth curve was generated from the collected data. At the maximum indentation depth, the load was kept constant for 10 s. No significant creep was observed in all samples. During the subsequent unloading segment, the tip is withdrawn to 10% of the maximum load and then held in contact with the surface for 60 s. The latter was used to correct the thermal drift. From the experimentally obtained load displacement curve, Young's modulus (E) and hardness (H) can be calculated based on their relationship with the contact area and the measured contact stiffness (S), as indicated above. Further, $H = P_{max}/A$. Typically the Berkovitch tip is calibrated, e.g. by using fused silica, e.g. to deduce tip area over a large range of indentation depths.

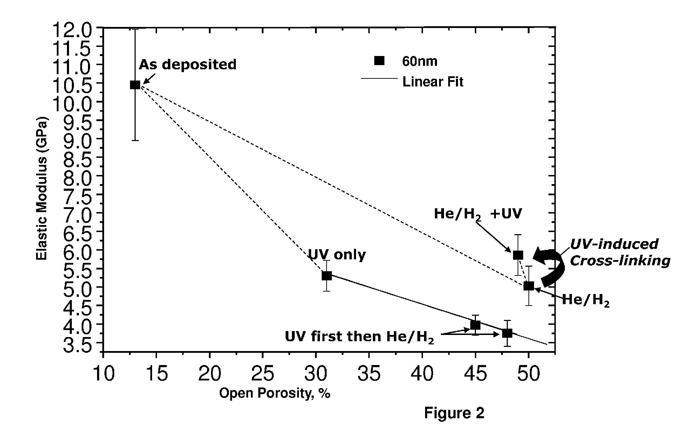

Figure 2 illustrates elastic modulus versus porosity of a PE-CVD or CVD deposited low-k film as deposited, after using state of the art curing methods and after using the curing method according to the examples (indicated as "He/H$_2$ + UV").

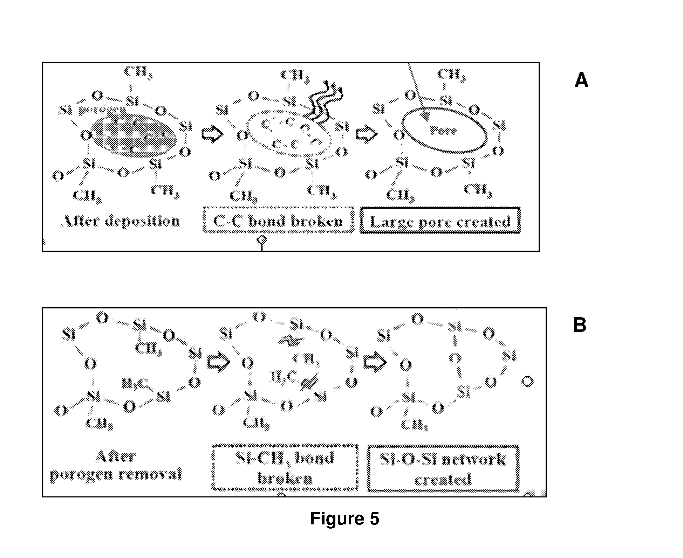

Figure 5 illustrates a supposed mechanism of cross-linking using the method of the examples. Figure 5A illustrates porogen removal within a deposited SiCOH film using the H$_2$ comprising DSP plasma treatment according to the examples. Figure 5B illustrates curing of a deposited SiCOH low-k film after total removal of porogens using a (subsequent) thermal UV curing step.

It is to be understood that although examples, specific constructions and configurations, as well as materials, have been discussed herein for devices according to the present invention, various changes or modifications in form and detail may be made without departing from the scope of this invention as defined by the appended claims.

All references cited herein are incorporated herein by reference in their entirety. To the extent publications and patents or patent applications incorporated by reference contradict the disclosure contained in the specification, the specification is intended to supersede and/or take precedence over any such contradictory material.

All numbers expressing quantities of ingredients, reaction conditions, and so forth used in the specification and claims are to be understood as being modified in all instances by the term "about." Accordingly, unless indicated to the contrary, the numerical parameters set forth in the specification and attached claims are approximations that may vary depending upon the desired properties sought to be obtained by the present invention. At the very least, and not as an attempt to limit the application of the doctrine of equivalents to the scope of the claims, each numerical parameter should be construed in light of the number of significant digits and ordinary rounding approaches.

**Claims**

1. A method for producing a porogen-residue-free ultra low-k film having a k of 1.8-2.6, preferably a k < 2.0, with a porosity higher than 45%, preferably higher than 48%, and an elastic modulus above 3 GPa such as above 5 GPa, said method comprising at least the steps of:

   - (a) Providing a substrate (1), such as Si,
   - (b) Depositing an organo-silica matrix comprising organic porogen, such as cyclic aromatic hydrocarbon, such as by a SiCOH film (2) using Plasma Enhanced Chemical Vapour Deposition (PE-CVD) or Chemical Vapour Deposition (CVD) or spin-on deposition, followed by
   - (c) Performing an porogen removal step, such as by atomic hydrogen treatment at a wafer temperature in the range of 200 °C up to 430 °C during a time of 10-800 sec., preferably during 10-700 sec., more preferably during 10-400 sec., and then followed by
   - (d) Performing a curing step, preferably a UV assisted thermal curing step, preferably at a wavelength of <200 nm, such as around 172 nm, and
   - Optionally repeating steps (b)-(c) one or more times and repeating step (d) one or more times.

2. The method according to claim 1, wherein said SiCOH film is a PE-CVD or CVD deposited SiCOH film with film thickness in between 20 nm and 190 nm, preferably in between 40 nm and 140 nm, optionally with film thickness of a multitude of 20 nm and 190 nm.

3. The method according to any of the foregoing claims wherein said atomic hydrogen treatment is performed in the afterglow of a hydrogen comprising plasma thereby avoiding the presence of hydrogen excited radicals, ions, electrons, and UV light.

4. The method according to any of the foregoing claims wherein said atomic hydrogen treatment is performed in the afterglow of a hydrogen comprising plasma and wherein said hydrogen plasma comprises an enhancer, such as an addition of one or more noble gases, such as He, Ne, Ar, Kr, and Xe.

5. The method according to any of the foregoing claims wherein said atomic hydrogen treatment is performed in the afterglow of a hydrogen comprising plasma and wherein said hydrogen plasma is operated at a microwave power in the range 100-2500 W, preferably 2500 W, and/or a gas pressure in the range 13.3 Pa (100 mTorr) up to 100-300 Pa (several Torr), more preferably around 100 Pa (750 mTorr) and/or a hydrogen gas flow around 950 sccm hydrogen.

6. The method according to any of the foregoing claims wherein said atomic hydrogen treatment is performed in the afterglow of a hydrogen comprising plasma wherein said hydrogen plasma comprises additions of noble gases such as He, Ne, Ar, Kr, and Xe and/or wherein the ratio of noble gas towards hydrogen is preferably from 1/1 to 50/1, such as 5/1 to 30/1, such as around 20/1.

7. The method according to any of the foregoing claims wherein said atomic hydrogen treatment is performed at elevated wafer temperature in the range of 200 °C up to 350 °C, such as 250 °C up to 300 °C, preferably around 280 °C.

8. The method according to any of the foregoing claims wherein said atomic hydrogen treatment is performed using catalytic conversion of $H_2$.

9. The method according to any of the foregoing claims wherein said UV assisted thermal curing step is performed in a temperature range of 300 °C up to 500 °C, such as from above 350 °C up to 450 °C, more preferably at a temperature of 430 °C.

10. A low-k film, such as an ILD or IMD, having a k-value k of 1.8-2.6, preferably a k < 2.0, more preferably a k < 1,8, having a porosity of 41%-60%, preferably higher than 48%, and high elastic modulus of above 2 GPa, preferably above 5 GPa, such as above 7 GPa, such as 9.5 GPa, preferably having a thickness of a multiple of 60-140 nm, preferably having an open porosity of less than 40%, such as 32%-36%, preferably having an average pore radius from 0.6 - 3.0 nm, more preferably from 0.7-2 nm, most preferably from 0.8-1.8 nm, such as from 1.5-1.6 nm, such as fabricated according to any of claims 1 to 9.

11. A method according to any of the claims 1 to 9, applied in fabrication of a low-k film.

12. Electronic element, such as diode, transistor, MEMS, capacitor, comprising a low-k film according to claim 10.

13. Semiconductor device comprising a low-k film according to claim 10.

14. Integrated circuit comprising a low-k film according to claim 10.

15. Electronic equipment or component, such as an RFID, television, audio, video, telephone, microphone, comprising a Semiconductor device according to claim 13, and/or an Integrated circuit according to claim 14, and/or an electronic element according to claim 12.

Figure 1

Figure 2

Figure 3

**4A**

**4B**

**4C**

**4D**

**Figure 4**

Figure 5

# EP 2 272 996 A1

## EUROPEAN SEARCH REPORT

Application Number

EP 10 16 8910

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BILODEAU S M ET AL: "CHEMICAL ROUTES TO IMPROVES MECHANICAL PROPERTIES OF PECVD LOW K THIN FILMS" MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, USA, vol. 812, 13 April 2004 (2004-04-13), pages 109-114, XP008050334 ISBN: 978-1-55899-828-5 * the whole document * | 1-15 | INV. C23C16/40 C23C16/56 H01L21/312 |
| X | EP 1 873 818 A2 (AIR PROD & CHEM [US]) 2 January 2008 (2008-01-02) * claims 1-13; figures 1-2; examples 1-20; table 1 * | 1-15 | |
| X | US 2008/220619 A1 (MATSUSHITA KIYOHIRO [JP] ET AL) 11 September 2008 (2008-09-11) * paragraph [0044] - paragraph [0077]; claims 1-9; figures 3-6 * | 1,2,9-15 | |
| X | US 2008/166498 A1 (CHEN MEI-LING [TW] ET AL) 10 July 2008 (2008-07-10) * paragraph [0030] - paragraph [0035]; claims 1-11; figure 1 * | 1,2,9,11 | TECHNICAL FIELDS SEARCHED (IPC) C23C H01L |

-/--

The present search report has been drawn up for all claims

| Place of search | Date of completion of the search | Examiner |
|---|---|---|
| The Hague | 1 October 2010 | Lavéant, Pierre |

EPO FORM 1503 03.82 (P04C01)

Europäisches
Patentamt

European
Patent Office

Office européen
des brevets

## EUROPEAN SEARCH REPORT

Application Number

EP 10 16 8910

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | KEMELING ET AL: "A robust k~2.3 SiCOH low-k film formed by porogen removal with UV-cure" MICROELECTRONIC ENGINEERING, ELSEVIER PUBLISHERS BV., AMSTERDAM, NL LNKD-DOI:10.1016/J.MEE.2007.05.025, vol. 84, no. 11, 25 September 2007 (2007-09-25), pages 2575-2581, XP022266640 ISSN: 0167-9317 | 10-15 | |
| A | * page 2576, column 1, line 17 - page 2577, column 1, line 10; figure 1; table 1 * | 1-9 | |
| A | GRILL A ET AL: "Hydrogen plasma effects on ultralow-k porous SiCOH dielectrics" JOURNAL OF APPLIED PHYSICS, AMERICAN INSTITUTE OF PHYSICS. NEW YORK, US LNKD-DOI:10.1063/1.2060935, vol. 98, no. 7, 4 October 2005 (2005-10-04), pages 74502-074502, XP012078734 ISSN: 0021-8979 * pages 074502-1, line 5 - line 35; figures 9-11; table 1 * * pages 074502-5, column 2, line 24 - pages 074502-6, column 2, line 27 * | 3-8 | TECHNICAL FIELDS SEARCHED (IPC) |

The present search report has been drawn up for all claims

| Place of search | Date of completion of the search | Examiner |
|---|---|---|
| The Hague | 1 October 2010 | Lavéant, Pierre |

EPO FORM 1503 03.82 (P04C01)

## ANNEX TO THE EUROPEAN SEARCH REPORT
## ON EUROPEAN PATENT APPLICATION NO.

EP 10 16 8910

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2010

| Patent document cited in search report | | Publication date | Patent family member(s) | | Publication date |
|---|---|---|---|---|---|
| EP 1873818 | A2 | 02-01-2008 | JP 2008010877 A<br>KR 20080000538 A<br>US 2007299239 A1 | | 17-01-2008<br>02-01-2008<br>27-12-2007 |
| US 2008220619 | A1 | 11-09-2008 | NONE | | |
| US 2008166498 | A1 | 10-07-2008 | NONE | | |

EPO FORM P0459

For more details about this annex : see Official Journal of the European Patent Office, No. 12/82

EP 2 272 996 A1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Kemeling et al.** *Microelectronic Engineering,* November 2007, vol. 84 (11), 2575-2581

- **Urbanowicz et al.** *Electrochemical Solid-State Letters,* vol. 12 (8

19